# FASCICULE DE BREVET EUROPEEN

(11) **EP 3 555 652 B1**
(45) Date de publication et mention de la délivrance du brevet: **14.04.2021**
(21) Numéro de dépôt: 17822397.0
(22) Date de dépôt: 11.12.2017
(51) Int. Cl.: G01R 35/00, H02P 6/10

(54) **PROCEDE DE COMPENSATION DYNAMIQUE DE L'ERREUR D'OFFSET D'UNE CHAINE D'ACQUISITION COMPORTANT UN CAPTEUR DE COURANT**
VERFAHREN ZUR DYNAMISCHEN KOMPENSATION DES VERSATZFEHLERS EINES ERFASSUNGSSYSTEMS MIT EINEM STROMSENSOR
METHOD FOR DYNAMIC COMPENSATION FOR THE OFFSET ERROR OF AN ACQUISITION SYSTEM COMPRISING A CURRENT SENSOR

(30) Priorité: 13.12.2016 FR 1662391
(43) Date de publication de la demande: 23.10.2019
(73) Titulaire: SEB S.A., 69130 Ecully (FR)
(72) Inventeur: COUTELLIER, Damien, 69310 Pierre Benite (FR); SCHMERBER, Louis, 38150 Roussillon (FR)
(74) Mandataire: SEB Développement
(86) Numéro de dépôt international: PCT/FR2017/053504
(87) Numéro de publication internationale: WO 2018/109351

(56) Documents cités:
- US-A1- 2014 239 861
- US-A1- 2014 253 004
- US-A1- 2016 276 969
- US-B2- 8 981 701

## Description

La présente invention se rapporte au domaine technique général de la métrologie industrielle en électronique.

Plus précisément, la présente invention se rapporte à un procédé de compensation dynamique de l'erreur d'offset d'une chaine d'acquisition comportant un capteur de courant agencé pour mesurer ou estimer le courant traversant un actionneur d'un appareil électrique alimenté électriquement par une tension alternative, ladite chaine d'acquisition présentant une valeur d'offset prédéterminée.

Un tel appareil électrique fait par exemple partie de la famille des appareils électroménagers.

Il est nécessaire dans les appareils électroménagers de mesurer le courant traversant différents actionneurs électriques ou électromécaniques de manière à en déduire la valeur d'une grandeur caractéristique nécessaire au fonctionnement de l'appareil.

C'est ainsi que sur certains appareils, la mesure de courant est réalisée par une chaine d'acquisition dédiée qui, associée à un moyen de traitement, permet par exemple de déterminer un couple de moteur, une puissance instantanée, une puissance consommée, la détection du franchissement d'un seuil ou bien de réaliser une régulation en courant.

La précision de ces déterminations dépend directement de la précision de la mesure de courant.

Or, cette précision dépend elle aussi directement du coût de la chaine d'acquisition et donc de l'appareil. Une chaine d'acquisition extrêmement précise sera beaucoup plus chère qu'une solution d'une précision moindre.

Il existe plusieurs types d'erreur sur une chaine d'acquisition de mesure conduisant à une imprécision de la mesure dont les principaux types sont une erreur d'offset, une erreur de gain et/ou une erreur due aux bruits.

La présente invention concerne tout particulièrement un procédé pour compenser l'erreur d'offset présente sur une chaine d'acquisition de mesure comportant un capteur de courant.

Chaque chaine d'acquisition présente un offset théorique plus généralement dénommée offset de la chaine d'acquisition.

Cet offset de la chaine d'acquisition est lié intrinsèquement aux différents composants utilisés dans la chaine d'acquisition et peut être calculé à partir des caractéristiques théoriques de ceux-ci.

La présence d'une erreur sur l'offset induit une dérive dans le temps de la mesure de courant par le capteur.

Cette dérive de mesure dans le temps d'une chaine d'acquisition est principalement liée à l'évolution de la température ambiante dans laquelle la chaine d'acquisition est intégrée au sein de l'appareil.

De plus, une évolution de la dérive de mesure d'une chaine d'acquisition est particulièrement significative sur des temps d'acquisitions relativement long allant de la seconde jusqu'à la dizaine de secondes.

Il est connu de mettre en œuvre plusieurs procédés pour compenser une erreur d'offset d'une chaine d'acquisition comportant un capteur de courant.

Les documents US5945853A et US6674322B2 décrivent un procédé par compensation active nécessitant un circuit dédié.

Cependant, ce procédé est coûteux et encombrant car il nécessite de rajouter un circuit annexe à la chaine d'acquisition existante.

Le document US8618789B2 décrit un procédé de mesure réalisant une moyenne sur un courant alternatif.

Cependant, ce procédé se limite uniquement aux courants alternatifs supposés à valeur moyenne nulle.

Les documents US8981701B2 et US20150214881A1 décrivent chacun un procédé de compensation passif et statique par mesure de l'offset juste avant le démarrage de la fonction de l'appareil.

Cependant, ce procédé se limite à une mesure statique uniquement au démarrage et ne permet pas de compenser dynamiquement l'erreur d'offset de la chaine d'acquisition en cours de fonctionnement de l'appareil.

Le document US20140253004A1 décrit un procédé qui permet, en utilisant le circuit existant et une séquence spécifique de pilotage d'un moteur, de compenser dynamiquement l'erreur d'offset d'une chaine d'acquisition comportant des capteurs de courants.

Cependant, ce procédé se limite uniquement aux moteurs Brushless DC ou aux moteurs synchrones à aimant permanent.

De plus, ce procédé comprend une séquence de compensation qui doit être exécutée périodiquement.

Aussi, la présente invention a pour but de résoudre tout ou partie des inconvénients mentionnés ci-dessus.

En particulier, un but de l'invention est donc de proposer un procédé de compensation dynamique de l'erreur d'offset d'une chaine d'acquisition comportant un capteur de courant pouvant être mis en œuvre dans le plus grand nombre d'appareils afin de conserver une précision accrue sur la mesure de courant et de limiter la dérive de la mesure dans le temps.

Un autre but consiste à pouvoir initier la séquence de compensation indifféremment de façon périodique ou apériodique.

A cet effet, la présente invention se rapporte à un procédé de compensation dynamique de l'erreur d'offset d'une chaine d'acquisition comportant un capteur de courant agencé pour mesurer ou estimer le courant traversant un actionneur d'un appareil électrique alimenté électriquement par une tension alternative, ladite chaine d'acquisition présentant une valeur d'offset prédéterminée, ledit procédé comportant les étapes suivantes :
- déterminer une pluralité de plages temporelles de fonctionnement périodiques de l'actionneur pour appliquer dynamiquement une séquence de compensation de l'erreur d'offset de la chaine d'acquisition,
- exécuter la séquence de compensation au cours de l'une quelconque parmi la pluralité de plages temporelles de fonctionnement déterminées,
   la synchronisation entre l'une quelconque des plages temporelles de fonctionnement déterminées de l'actionneur et l'exécution de la séquence de compensation étant réalisée à partir de moyens de synchronisation comprenant un module de synchronisation agencé pour identifier des instants de référence à partir de la tension alternative d'alimentation du secteur, ladite séquence de compensation comprenant les étapes suivantes :
   (i) arrêter l'alimentation électrique de l'actionneur de manière à interrompre le passage de courant dans le capteur de courant,
   (ii) attendre une durée prédéterminée au bout de laquelle il est considéré ou estimé que le courant ne traverse plus le capteur de courant,
   (iii) mesurer une valeur d'offset réel de la chaine d'acquisition,
   (iv) considérer cette valeur d'offset réel comme nouvelle valeur d'offset de la chaine d'acquisition,
   (v) alimenter électriquement l'actionneur de manière à assurer le passage de courant dans le capteur de courant,
   (vi) utiliser la nouvelle valeur d'offset de la chaine d'acquisition pour piloter l'actionneur.

Cette disposition permet de compenser d'une manière simple et peu coûteuse l'erreur d'offset d'une chaine d'acquisition comportant un capteur de courant.

La durée prédéterminée au bout de laquelle il est considéré que le courant ne traverse plus le capteur de courant est liée intrinsèquement au type d'actionneur et aux composants de la chaine d'acquisition.

La présente invention ne se limite pas uniquement aux moteurs Brushless DC ou aux machines synchrones à aimant permanent mais peut se décliner pour d'autres actionneurs électroniques, mécaniques ou électromécaniques nécessitant une mesure de courant.

La présente invention est capable de corriger l'erreur d'offset d'une chaine d'acquisition comportant un capteur de courant mesurant un courant continu ou un courant alternatif ou un courant continu comportant une composante alternative (modulation).

Les plages temporelles de fonctionnement sont périodiques mais la séquence de compensation peut être appliquée de façon périodique ou de façon apériodique au cours de l'une quelconque de ces plages temporelles de fonctionnement.

La présente invention nécessite une mesure annexe qui va permettre de synchroniser l'exécution de la séquence de compensation et une plage temporelle de fonctionnement déterminée.

En outre, ce procédé est transposable à toute carte électronique intégrant une chaine d'acquisition comportant un capteur de courant, et un actionneur dont la constante de temps est largement supérieure à quelques millisecondes.

Selon une mise en œuvre du procédé, la durée prédéterminée au bout de laquelle il est considéré que le courant ne traverse plus le capteur de courant est liée intrinsèquement au type d'actionneur et aux composants de la chaine d'acquisition.

Cette durée est ainsi plus ou moins longue en fonction de la chaine d'acquisition et de l'actionneur.

Selon une mise en œuvre du procédé, les plages temporelles sont déterminées de sorte que l'exécution de la séquence de compensation ne modifie pas la valeur d'une caractéristique de fonctionnement déterminée de l'actionneur au-delà d'un seuil déterminé.

Une telle caractéristique de fonctionnement peut par exemple comprendre le bruit associé au démarrage d'un générateur à induction, la température d'un ustensile chauffé par le générateur à induction, ou bien la vitesse ou le couple d'un moteur.

Ainsi, la présente invention est capable de réaliser la compensation de l'erreur d'offset d'une chaine d'acquisition de façon statique au démarrage mais également dynamiquement, c'est-à-dire en cours de fonctionnement de l'appareil et cela sans que l'utilisateur ne constate de modification sur le fonctionnement de l'appareil, notamment une variation du bruit associé au démarrage d'un générateur à induction, une variation de température d'un ustensile chauffé par le générateur à induction, ou bien une variation de la vitesse ou du couple d'un moteur.

Selon une mise en œuvre du procédé, l'actionneur est un générateur à induction, un moteur universel ou un moteur asynchrone piloté par une électronique appropriée, le moteur asynchrone étant associé à un circuit électronique agencé pour empêcher le fonctionnement du moteur dans un mode générateur pendant les plages temporelles.

Selon une mise en œuvre du procédé, l'une quelconque des plages temporelles de fonctionnement déterminées comprend l'instant du passage par une valeur nulle de la tension alternative d'alimentation du secteur, et le cas échéant la caractéristique de fonctionnement déterminée du générateur à induction comprend le niveau sonore du bruit émis par le générateur à induction lors de la transmission d'énergie depuis le générateur à induction vers un ustensile à chauffer, ou la variation de température de l'ustensile à chauffer, et le cas échéant la caractéristique de fonctionnement déterminée de l'actionneur comprend la vitesse de rotation ou le couple du moteur.

Selon une mise en œuvre du procédé, l'actionneur est un moteur à courant continu ou un moteur synchrone à aimant permanent, chacun de ces moteurs étant associé à un circuit électronique agencé pour empêcher le fonctionnement du moteur dans un mode générateur pendant les plages temporelles.

Selon une mise en œuvre du procédé, l'une quelconque des plages temporelles de fonctionnement déterminées comprend l'instant du passage par la valeur maximale et/ou minimale de la tension alternative d'alimentation du secteur, et la caractéristique de fonctionnement déterminée du moteur comprend la vitesse de rotation ou le couple du moteur.

La présente invention se rapporte également à un appareil électrique destiné à être alimenté électriquement par une tension alternative, et comprenant :
- un actionneur,
- une chaine d'acquisition comprenant un capteur de courant destiné à mesurer ou estimer le courant traversant l'actionneur, et
   dans le cas où l'actionneur est un moteur comprenant un mode de fonctionnement en générateur, alors l'appareil électrique comprend un circuit électronique connecté au moteur et agencé pour empêcher le fonctionnement du moteur dans son mode générateur pendant les plages temporelles,
- des moyens de synchronisation pour déterminer une pluralité de plages temporelles de fonctionnement périodiques de l'actionneur pour exécuter dynamiquement une séquence de compensation de l'erreur d'offset de la chaine d'acquisition au cours de l'une quelconque parmi la pluralité de plages temporelles de fonctionnement déterminées, lesdits moyens de synchronisation comprenant un module de synchronisation agencé pour identifier des instants de référence à partir de la tension alternative d'alimentation du secteur,
- des moyens de traitements agencés pour mettre en œuvre un procédé tel que décrit précédemment.

L'invention est plus favorablement utilisée pour des appareils comportant des éléments de puissance intégrant un capteur de courant tels que :
- des appareils comportant un moteur et ce quel que soit le type de moteur,
- des appareils comportant un élément chauffant comme une résistance de toute nature sérigraphiée ou brasée,
- des appareils comportant un générateur à induction.

Un module de synchronisation est déjà présent dans la plupart des appareils électriques aptes à être alimentés en tension alternative par le secteur et nécessitant un signal d'horloge.

Selon un aspect de l'invention, l'actionneur est un générateur à induction, un moteur asynchrone piloté par une électronique appropriée, un moteur synchrone à aimant permanent ou un moteur universel.

D'autres avantages et caractéristiques de l'invention ressortiront mieux à la lecture de la description détaillée de l'invention faite à titre illustratif et non limitatif en référence aux figures qui illustrent tout ou partie d'un procédé de compensation de l'erreur d'offset selon l'invention.
La figure 1 illustre une première architecture classique d'un circuit électrique d'un générateur à induction.
La figure 2 illustre une deuxième architecture classique d'un circuit électrique d'un générateur à induction.
La figure 3 illustre la manière avec laquelle sont déterminées les plages temporelles de fonctionnement au cours desquelles il est opportun d'exécuter une séquence de compensation d'un procédé de compensation dynamique de l'erreur d'offset d'une chaine d'acquisition dans un générateur à induction ou un moteur universel ou un moteur asynchrone piloté par une électronique appropriée.
La figure 4 illustre l'évolution temporelle des signaux électriques utilisés pour mettre en œuvre un procédé de compensation dynamique de l'erreur d'offset d'une chaine d'acquisition dans un générateur à induction.
La figure 5 illustre la manière avec laquelle sont déterminées les plages temporelles de fonctionnement au cours desquelles il est opportun d'exécuter une séquence de compensation d'un procédé de compensation dynamique de l'erreur d'offset d'une chaine d'acquisition dans un moteur synchrone à aimant permanent ou un moteur à courant continu.
La figure 6 illustre l'évolution temporelle des signaux électriques utilisés pour mettre en œuvre un procédé de compensation dynamique de l'erreur d'offset d'une chaine d'acquisition dans un moteur synchrone à aimant permanent.
La figure 7 illustre une architecture classique d'un circuit électrique pour un moteur universel intégrant un hacheur.
La figure 8 illustre l'évolution temporelle des signaux électriques utilisés pour mettre en œuvre un procédé de compensation dynamique de l'erreur d'offset d'une chaine d'acquisition dans un moteur universel.
La figure 9 est un ordinogramme illustrant les étapes d'une séquence de compensation d'un procédé selon l'invention.

Seuls les éléments nécessaires à la compréhension de l'invention ont été représentés. Pour faciliter la lecture des dessins, les mêmes éléments portent les mêmes références d'une figure à l'autre.

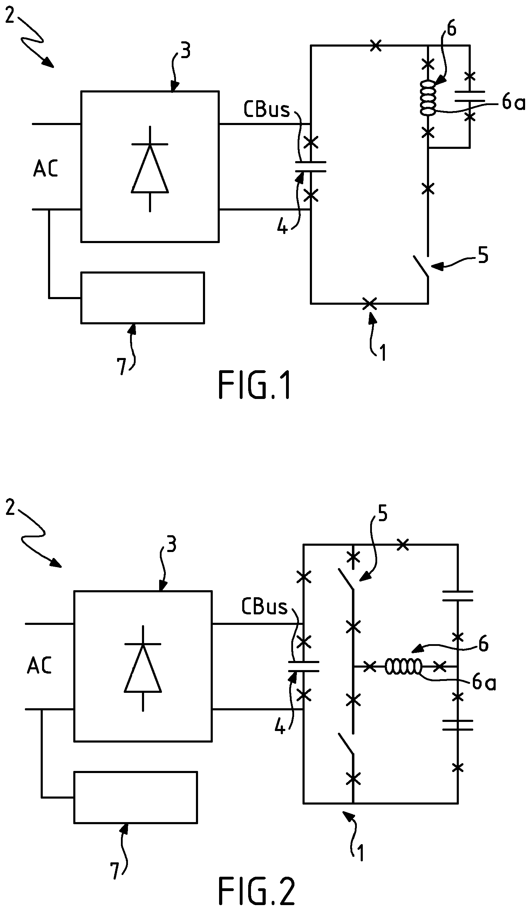

Dans l'exemple proposé aux figures 1 et 2, l'actionneur 6 est un générateur à induction 6a.

Les architectures classiques d'un circuit électrique 2 d'un générateur à induction 6a illustrées sur ces deux figures 1 et 2, intègrent une mesure de courant permettant de maitriser l'amplitude du courant et la puissance transmise aux matériaux à chauffer.

Cette mesure de courant est critique et fondamentale dans le fonctionnement du générateur à induction 6a. Une petite erreur sur la mesure implique une erreur significative sur le courant dans le générateur à induction 6a et donc sur la puissance transmise aux matériaux à chauffer.

Afin de mesurer ou d'estimer le courant traversant le générateur à induction 6a, un capteur de courant 1 peut être positionné aux différents endroits du circuit électrique 2 matérialisés par une croix sur les figures 1 et 2.

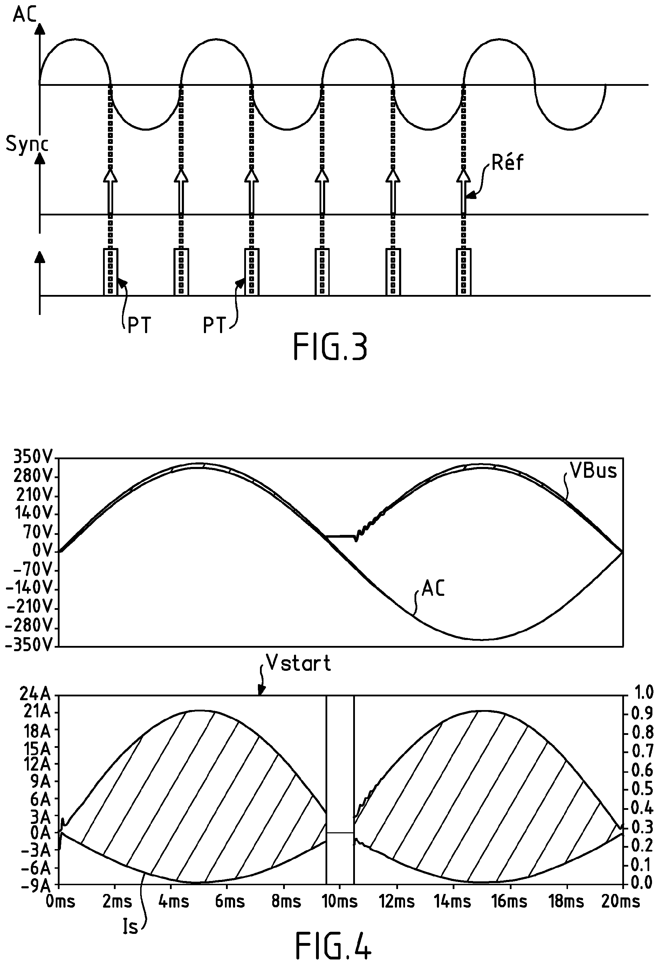

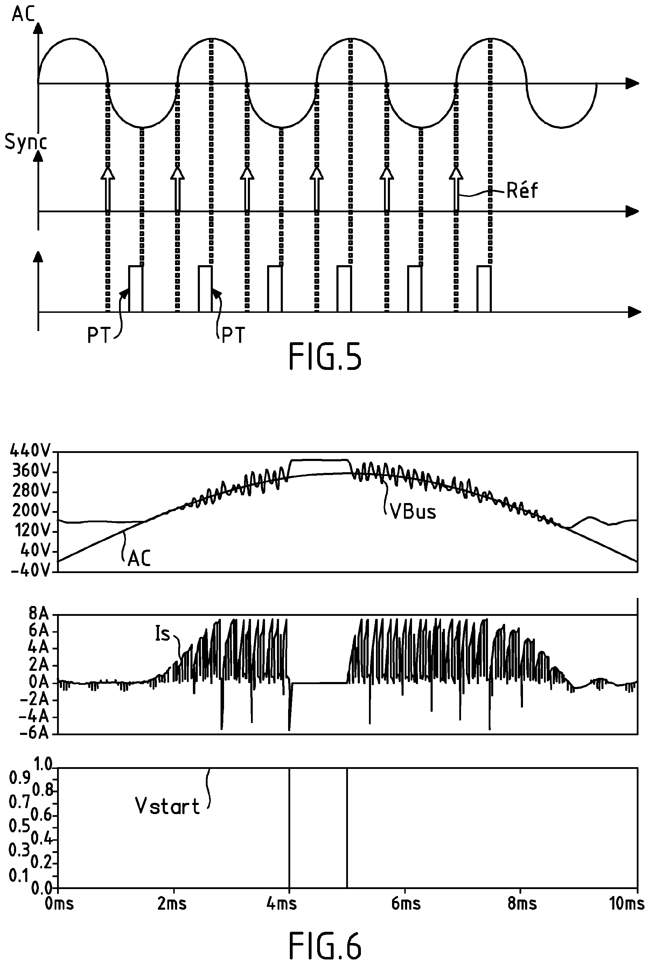

Dans les simulations proposées aux figures 4 et 6, la mesure de courant est réalisée à l'endroit où une croix est entourée.

Dans l'exemple proposé, le circuit électrique 2 comprend en outre un redresseur de tension 3, des condensateurs 4 et des interrupteurs de puissance 5.

Ce circuit électrique 2 est alimenté par une tension alternative fournie par le secteur et dont la forme du signal est illustrée sur la partie haute des figures 3 et 5.

En outre, ce circuit électrique 2 est relié en amont du redresseur de tension 3 à des moyens de synchronisation comprenant un module de synchronisation 7.

Ce module de synchronisation 7 permet de définir des instants de référence Réf à partir de la tension alternative d'alimentation AC du secteur C.

Bien entendu, le module de synchronisation 7 pourrait être relié différemment au redresseur de tension 3, notamment en aval de celui-ci.

Dans ce cas, les instants de référence Réf sont définis à des moments où le signal change de pente, c'est-à-dire au maximum et/ou au passage par la valeur nulle de la tension redressée du bus.

Le procédé selon l'invention comprend une étape consistant à déterminer une pluralité de plages temporelles PT de fonctionnement périodiques de l'actionneur pour appliquer dynamiquement une séquence de compensation SC de l'erreur d'offset de la chaine d'acquisition.

Ces plages temporelles PT sont périodiques et déterminées de sorte que l'exécution de la séquence de compensation SC ne modifie pas la valeur d'une caractéristique de fonctionnement déterminée de l'actionneur au-delà d'un seuil déterminé.

En outre, ces plages temporelles PT sont synchronisées par rapport aux instants de référence Réf définis par le module de synchronisation 7.

Néanmoins, une séquence de compensation SC peut être exécutée au cours de l'une quelconque parmi la pluralité de plages temporelles PT de fonctionnement déterminées.

Par exemple, le principe de fonctionnement du générateur à induction 6a est que lorsque la tension maximale d'alimentation AC est présente sur l'entrée du redresseur de tension 3 alors la puissance disponible pour chauffer le récipient et donc le courant mesuré par le capteur de courant 1 est maximale.

A l'inverse, lorsque la tension d'alimentation AC est nulle alors le courant ne traverse plus le capteur de courant 1 et la puissance fournie au générateur à induction 6a est théoriquement nulle.

Ainsi, lorsque la tension d'alimentation AC est quasi nulle alors on peut considérer que la puissance transmise est négligeable par rapport à la puissance transmise lorsque la tension d'alimentation AC est maximale.

La séquence de compensation SC pour un générateur à induction 6a doit donc être exécutée lorsque la tension d'alimentation AC est inférieure à un seuil déterminé, par exemple comprise entre plus ou moins 15% de l'amplitude de la tension d'alimentation AC maximale ou minimale.

De cette manière, la séquence de compensation SC ne modifiera pas la valeur d'un paramètre de fonctionnement déterminé du générateur à induction au-delà d'un seuil déterminé.

Par exemple, pour une tension d'alimentation AC nominale de 230V/50Hz, il apparaît opportun d'exécuter la séquence de compensation SC lorsque la tension d'alimentation AC est comprise entre -50V et +50V, ce qui correspond à des plages temporelles PT de fonctionnement de quelques millisecondes.

Comme illustré à la figure 3, ces plages temporelles PT de fonctionnement sont par exemple de 2 ms et sont centrées sur l'instant du passage par une valeur nulle de la tension alternative d'alimentation AC du secteur.

Dans le cas d'un générateur à induction 6a, la caractéristique de fonctionnement peut être le bruit induit par le générateur à induction lors de la transmission d'énergie depuis le générateur à induction 6a vers un ustensile à chauffer ou bien la variation de la température de l'ustensile à chauffer.

Cet ustensile peut par exemple être disposé sur une plaque à induction ou bien dans un appareil de préparation culinaire.

Ainsi, au cours de l'exécution de la séquence de compensation SC pendant la plage temporelle de fonctionnement déterminée, le niveau sonore du bruit induit par le générateur à induction est inférieur à un seuil de bruit déterminé, ou bien la variation de température est inférieure à un seuil déterminé, ce qui présente l'avantage pour l'utilisateur du générateur à induction de ne pas s'apercevoir d'un changement dans le fonctionnement du générateur à induction.

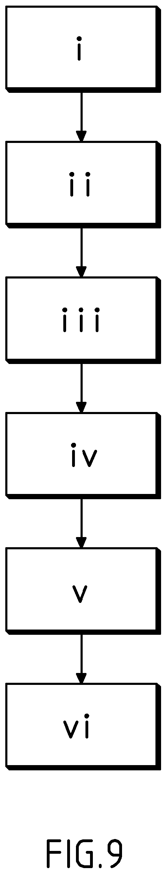

La séquence de compensation SC comprend plusieurs étapes illustrées à la figure 9.

La première étape (i) consiste à arrêter l'alimentation électrique du générateur à induction 6a de manière à interrompre le passage du courant dans le capteur de courant 1.

Comme illustré à la figure 4, lors de cette étape le courant va commencer à s'annuler au travers du capteur de courant 1.

Sur cette figure 4, le signal VBus correspond à la tension aux bornes du condensateur CBus placé en sortie du redresseur de tension 3 sur l'architecture du circuit électrique 2 illustré à la figure 2.

Ce signal VBus correspond à la tension alternative d'alimentation redressée par le redresseur de tension 3.

Ce signal VBus ne comprend donc qu'une composante positive.

Le signal Vstart correspond quant à lui au signal de commande permettant d'arrêter et de rétablir l'alimentation, et donc d'interdire et d'autoriser le passage du courant dans le générateur à induction 6a et donc dans le capteur 1 de la chaine d'acquisition.

Ce signal Vstart définit ainsi les plages temporelles PT au cours desquelles la séquence de compensation SC est exécutée.

Comme illustré à la figure 4, ce signal de commande Vstart est synchronisé sur le signal Sync transmis par le module de synchronisation 7.

Sur la figure 4, cette plage temporelle est de 1 ms et est située entre 9.5 ms et 10.5 ms.

Le signal Is correspondant à la valeur du courant électrique mesuré par un capteur de courant 1 en sortie du redresseur de tension 3.

Au cours d'une deuxième étape (ii), on attend une durée prédéterminée au bout de laquelle il est considéré ou estimé que le courant ne traverse plus le capteur de courant 1.

Cette durée correspond généralement à la constante de temps du circuit électrique 2.

Cette durée est très courte pour un générateur à induction 6a.

Sur la figure 4, on s'aperçoit que le courant Is s'annule quasi instantanément dans le capteur de courant 1 lorsque le signal de commande Vstart arrête l'alimentation.

Au cours d'une troisième étape (iii), on mesure une valeur d'offset réel de la chaine d'acquisition.

Cette mesure permet de mettre en évidence le décalage entre l'offset qui était jusqu'alors considéré et l'offset réel de la chaine d'acquisition.

En effet, étant donné qu'après la durée déterminée il est considéré que le courant ne traverse plus le capteur de courant 1 alors la valeur mesurée à cet instant là par le capteur de courant 1 devrait théoriquement correspondre à l'offset réel de la chaine d'acquisition.

Il convient donc d'étalonner le capteur de courant 1 au cours d'une quatrième étape (iv) en considérant cet offset réel comme la nouvelle valeur de l'offset de la chaine d'acquisition.

Une fois l'offset de la chaine d'acquisition corrigé alors au cours d'une cinquième étape (v) le signal de commande Vstart rétablit l'alimentation du générateur à induction 6a de manière à assurer le passage du courant dans le capteur de courant.

Lors d'une étape subséquente (vi), la nouvelle valeur d'offset de la chaine d'acquisition est utilisée pour piloter l'actionneur.

Au cours de cette séquence de compensation SC, l'utilisateur ne perçoit aucun changement sur le fonctionnement de son générateur à induction.

La mise en œuvre du procédé décrit ci-dessus en référence à un générateur à induction peut de façon analogue être mise en œuvre pour un moteur universel ou un moteur asynchrone piloté par une électronique approprié, par exemple un onduleur.

En considérant une mise en œuvre pour un moteur asynchrone, l'homme du métier sait que dans ce cas le moteur doit être associé à un circuit électronique agencé pour empêcher le fonctionnement du moteur dans un quadrant générateur pendant les plages temporelles au cours desquelles la séquence de compensation est exécutée.

De façon avantageuse, une séquence de compensation SC comprenant les mêmes étapes peut également être exécutée lorsque l'actionneur est un moteur synchrone à aimant permanent, en particulier un moteur synchrone sans balais ou un moteur à courant continu.

Tout comme pour le moteur universel, on distingue deux modes de fonctionnement pour un moteur synchrone à aimant permanent ou un moteur à courant continu.

Un premier mode de fonctionnement en générateur où le moteur restitue de l'énergie, et un deuxième mode de fonctionnement en moteur où l'énergie est fournie par l'électronique au moteur.

Dans la majorité des appareils électriques intégrant des moteurs synchrones à aimant permanent ou un moteur à courant continu, le premier mode de fonctionnement en générateur n'est pas contrôlé de par les architectures du circuit électronique, qui intègrent notamment des diodes de roue libre.

Ainsi, de tels moteurs fonctionnent selon leur premier mode de fonctionnement en générateur lorsque la valeur de la tension alternative alimentant le moteur est inférieure à la force électromotrice du moteur et fonctionne selon son deuxième mode de fonctionnement en moteur lorsque cette même valeur est supérieure à la force électromotrice du moteur.

Dans le premier mode de fonctionnement en générateur le moteur alimente l'électronique, à travers les diodes de roue libre.

Par conséquent, il n'est pas possible de s'assurer que le courant s'annule dans le capteur de courant 1 lorsque l'alimentation du moteur est coupée.

Ce n'est donc pas au cours du premier mode de fonctionnement en générateur que la séquence de compensation SC doit être exécutée. Au cours du deuxième mode de fonctionnement en moteur, l'énergie transite de l'alimentation du secteur vers le moteur.

Dans ce deuxième mode de fonctionnement, la tension de l'alimentation AC du secteur est supérieure à la force électromotrice du moteur.

Ainsi, lorsque l'alimentation du moteur est arrêtée à un instant où celui-ci était dans son deuxième mode de fonctionnement en moteur alors le moteur ne fonctionnera pas selon son premier mode de fonctionnement en générateur car l'architecture électronique ne le permet pas.

L'énergie mécanique du moteur se dissipe alors sous forme de pertes mécaniques et le courant s'annule dans le moteur et dans le capteur de courant 1.

Au cours de cette période, il est alors possible de réaliser la séquence de compensation SC de l'erreur d'offset de la chaine d'acquisition.

Il serait également possible d'exécuter la séquence de compensation SC sur d'autres plages temporelles PT déterminées, si le moteur est associé à un circuit électronique agencé pour empêcher le fonctionnement du moteur dans un quadrant générateur pendant ces autres plages temporelles.

Comme illustré à la figure 5, dans l'exemple présenté les plages temporelles PT de fonctionnement du moteur synchrone à aimant permanent sont déterminées peu avant l'instant où la tension d'alimentation AC du secteur atteint sa valeur maximale.

Ces plages temporelles PT sont ainsi synchronisées sur ces instants de référence Réf grâce au module de synchronisation 7, l'intervalle de temps entre le signal délivré par le module de synchronisation 7 et le début de la plage temporelle étant constant.

Dans l'exemple présenté, les plages temporelles PT de fonctionnement sont de 1 ms.

Dans le cas d'un moteur, la caractéristique de fonctionnement déterminée peut être la vitesse de rotation ou bien le couple du rotor.

Ainsi, au cours de l'exécution de la séquence de compensation SC pendant les plages temporelles PT de fonctionnement déterminées, la vitesse et le couple de rotation du moteur de par son inertie mécanique, sont supérieurs à un seuil de vitesse ou de couple déterminé, ce qui présente l'avantage pour l'utilisateur du moteur de ne pas s'apercevoir d'un changement dans le fonctionnement du moteur, notamment de par l'absence d'à-coups.

La séquence de compensation SC comprend les mêmes étapes (i) à (vi) décrites ci-dessus en référence au générateur à induction 6a.

Sur la figure 6, le signal VBus correspond à la tension aux bornes du condensateur 4 situé en sortie du redresseur 3.

Le signal Vstart correspond quant à lui au signal de commande permettant d'arrêter et de rétablir l'alimentation du moteur.

Cependant, contrairement au générateur à induction 6a ce signal n'interdit le passage du courant dans le capteur de courant 1 que dans les cas où le signal VBus à l'instant de l'arrêt est supérieur à la force électromotrice du moteur.

Tout comme pour le générateur à induction 6a, le signal Vstart définit les plages temporelles PT au cours desquelles la séquence de compensation SC est exécutée.

Comme illustré à la figure 6, ce signal de commande Vstart est synchronisé sur le signal Sync transmis par le module de synchronisation 7.

Sur la figure 6, cette plage temporelle est de 1 ms et est située entre 4 ms et 5 ms.

Le signal Is correspondant à la valeur du courant électrique mesuré par un capteur de courant 1.

Sur la figure 6, on s'aperçoit également que le courant Is met un peu plus de temps à s'annuler dans le capteur de courant 1 que dans le cas du générateur à induction 6a lorsque le signal de commande Vstart arrête l'alimentation du moteur.

Néanmoins, ce temps est bien inférieur à la durée d'une plage temporelle au cours de laquelle peut être exécutée une séquence de compensation SC.

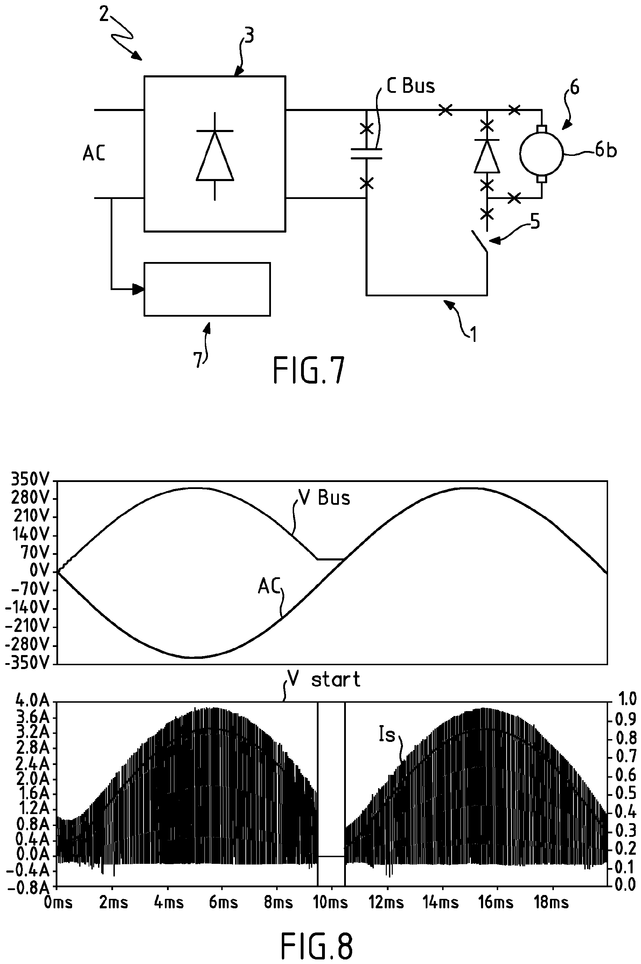

Dans l'exemple proposé à la figure 7, l'actionneur 6 est un moteur universel 6b.

Ce circuit électrique 2 comprend les mêmes éléments sur celui décrit précédemment pour un générateur à induction 6a.

Afin de mesurer ou d'estimer le courant traversant le moteur universel 6b, un capteur de courant 1 peut être positionné aux différents endroits du circuit électrique 2 matérialisés par une croix.

Dans la simulation proposée à la figure 8, la mesure de courant est réalisée à l'endroit où une croix est entourée.

Pour un moteur universel 6b, la séquence de compensation SC peut être exécutée à n'importe quel instant.

Néanmoins, tout comme pour le générateur à induction la séquence de compensation est préférablement exécutée dans des plages temporelles PT de fonctionnement centrées sur l'instant du passage par une valeur nulle de la tension alternative d'alimentation AC du secteur.

En effet, à la différence d'un moteur synchrone à aimant permanent, ce type de moteur ne peut pas fonctionner en mode générateur car la force électromotrice et le courant sont toujours de même signe.

De même que pour le générateur à induction ou le moteur synchrone à aimant permanent, la durée des plages temporelles PT dépend des caractéristiques du moteur (inductance, résistance...) et des caractéristiques de la chaine d'acquisition (localisation de la mesure, type de circuit de conditionnement...) et est de quelques millisecondes.

Bien que l'invention ait été décrite en liaison avec des exemples particuliers de réalisation, il est bien évident qu'elle n'y est nullement limitée.

Des modifications restent possibles, notamment du point de vue de l'agencement et de la constitution des différents éléments, sans sortir pour autant du domaine de protection de l'invention.

## Revendications

1. Procédé de compensation dynamique de l'erreur d'offset d'une chaine d'acquisition comportant un capteur de courant (1) agencé pour mesurer ou estimer le courant traversant un actionneur (6) d'un appareil électrique alimenté électriquement par une tension alternative, ladite chaine d'acquisition présentant une valeur d'offset prédéterminée, ledit procédé comportant les étapes suivantes :
- déterminer une pluralité de plages temporelles (PT) de fonctionnement périodiques de l'actionneur (6) pour appliquer dynamiquement une séquence de compensation (SC) de l'erreur d'offset de la chaine d'acquisition,
- exécuter la séquence de compensation (SC) au cours de l'une quelconque parmi la pluralité de plages temporelles (PT) de fonctionnement déterminées,
la synchronisation entre l'une quelconque des plages temporelles (PT) de fonctionnement déterminées de l'actionneur (6) et l'exécution de la séquence de compensation (SC) étant réalisée à partir de moyens de synchronisation comprenant un module de synchronisation (7) agencé pour identifier des instants de référence (Réf) à partir de la tension alternative d'alimentation (AC) du secteur, ladite séquence de compensation (SC) comprenant les étapes suivantes :
(i) arrêter l'alimentation électrique de l'actionneur de manière à interrompre le passage de courant dans le capteur de courant (1),
(ii) attendre une durée prédéterminée au bout de laquelle il est considéré ou estimé que le courant ne traverse plus le capteur de courant (1),
(iii) mesurer une valeur d'offset réel de la chaine d'acquisition,
(iv) considérer cette valeur d'offset réel comme nouvelle valeur d'offset de la chaine d'acquisition,
(v) alimenter électriquement l'actionneur (6) de manière à assurer le passage de courant dans le capteur de courant (1),
(vi) utiliser la nouvelle valeur d'offset de la chaine d'acquisition pour piloter l'actionneur (6).

2. Procédé selon la revendication 1, dans lequel les plages temporelles (PT) sont déterminées de sorte que l'exécution de la séquence de compensation (SC) ne modifie pas la valeur d'une caractéristique de fonctionnement déterminée de l'actionneur (6) au-delà d'un seuil déterminé.

3. Procédé selon l'une des revendications 1 ou 2 dans lequel l'actionneur (6) est un générateur à induction, un moteur universel ou un moteur asynchrone piloté par une électronique appropriée, le moteur asynchrone étant associé à un circuit électronique agencé pour empêcher le fonctionnement du moteur dans un mode générateur pendant les plages temporelles (PT).

4. Procédé selon la revendication 3, dans lequel l'une quelconque des plages temporelles (PT) de fonctionnement déterminées comprend l'instant du passage par une valeur nulle de la tension alternative d'alimentation (AC) du secteur, et le cas échéant la caractéristique de fonctionnement déterminée du générateur à induction comprend le niveau sonore du bruit émis par le générateur à induction lors de la transmission d'énergie depuis le générateur à induction vers un ustensile à chauffer, ou la variation de température de l'ustensile à chauffer et le cas échéant la caractéristique de fonctionnement déterminée de l'actionneur comprend la vitesse de rotation ou le couple du moteur.

5. Procédé selon l'une des revendications 1 ou 2, dans lequel l'actionneur (6) est un moteur à courant continu ou un moteur synchrone à aimant permanent, chacun de ces moteurs étant associé à un circuit électronique agencé pour empêcher le fonctionnement du moteur dans un mode générateur pendant les plages temporelles.

6. Procédé selon la revendication 5, dans lequel l'une quelconque des plages temporelles (PT) de fonctionnement déterminées comprend l'instant du passage par la valeur maximale et/ou minimale de la tension alternative d'alimentation (AC) du secteur, et la caractéristique de fonctionnement déterminée du moteur comprend la vitesse de rotation ou le couple du moteur.

7. Appareil électrique destiné à être alimenté électriquement par une tension alternative, et comprenant :
- un actionneur (6),
- une chaine d'acquisition comprenant un capteur de courant (1) destiné à mesurer ou estimer le courant traversant l'actionneur (6), et
dans le cas où l'actionneur (6) est un moteur comprenant un mode de fonctionnement en générateur, alors l'appareil électrique comprend un circuit électronique connecté au moteur et agencé pour empêcher le fonctionnement du moteur dans son mode générateur pendant les plages temporelles,
- des moyens de synchronisation pour déterminer une pluralité de plages temporelles (PT) de fonctionnement périodiques de l'actionneur (6) pour exécuter dynamiquement une séquence de compensation (SC) de l'erreur d'offset de la chaine d'acquisition au cours de l'une quelconque parmi la pluralité de plages temporelles (PT) de fonctionnement déterminées, lesdits moyens de synchronisation comprenant un module de synchronisation (7) agencé pour identifier des instants de référence (Réf) à partir de la tension alternative d'alimentation (AC) du secteur,
- des moyens de traitements agencés pour mettre en œuvre un procédé selon l'une des revendications 1 à 6.

8. Appareil électrique selon la revendication 7, dans lequel l'actionneur est un générateur à induction (6a), un moteur asynchrone piloté par une électronique appropriée, un moteur synchrone à aimant permanent ou un moteur universel (6b).

## Patentansprüche

1. Verfahren zur dynamischen Kompensation des Versatzfehlers einer Erfassungskette, die einen Stromsensor (1) umfasst, der angeordnet ist, um den Strom zu messen oder zu schätzen, der durch einen Aktuator (6) einer elektrischen Einrichtung fließt, die elektrisch durch eine Wechselspannung versorgt wird, wobei die Erfassungskette einen vorbestimmten Versatzwert aufweist, wobei das Verfahren die folgenden Schritte umfasst:
- Bestimmen einer Vielzahl von periodischen Betriebszeitbereichen (PT) des Aktuators (6), um dynamisch eine Kompensationssequenz (SC) des Versatzfehlers der Erfassungskette anzuwenden,
- Ausführen der Kompensationssequenz (SC) während eines beliebigen aus der Vielzahl der bestimmten Betriebszeitbereiche (PT),
wobei die Synchronisation zwischen einem beliebigen der bestimmten Betriebszeitbereiche (PT) des Aktuators (6) und der Ausführung der Kompensationssequenz (SC) von Synchronisationsmitteln ausgeführt wird, die ein Synchronisationsmodul (7) umfassen, das so angeordnet ist, dass es Referenzzeitpunkte (Ref) aus der Versorgungswechselspannung (AC) des Stromnetzes identifiziert, wobei die Kompensationssequenz (SC) die folgenden Schritte umfasst:
(i) Anhalten der elektrischen Versorgung des Aktuators, um den Stromfluss in dem Stromsensor (1) zu unterbrechen,
(ii) Abwarten einer vorbestimmten Zeitdauer, nach der angenommen oder geschätzt wird, dass der Strom nicht mehr durch den Stromsensor (1) fließt,
(iii) Messen eines realen Versatzwertes der Erfassungskette,
(iv) Betrachten dieses aktuellen Versatzwertes als den neuen Versatzwert der Erfassungskette,
(v) elektrisches Versorgen des Aktuators (6), um den Stromfluss in dem Stromsensor (1) sicherzustellen,
(vi) Verwenden des neuen Versatzwertes der Erfassungskette zur Ansteuerung des Aktuators (6).

2. Verfahren nach Anspruch 1, wobei die Zeitbereiche (PT) so bestimmt werden, dass die Ausführung der Kompensationssequenz (SC) den Wert einer bestimmten Betriebscharakteristik des Aktuators (6) nicht über einen bestimmten Schwellenwert hinaus verändert.

3. Verfahren nach einem der Ansprüche 1 oder 2, wobei der Aktuator (6) ein Induktionsgenerator, ein Universalmotor oder ein von einer geeigneten Elektronik angesteuerter Asynchronmotor ist, wobei dem Asynchronmotor eine elektronische Schaltung zugeordnet ist, die angeordnet ist, um den Betrieb des Motors in einem Generatormodus während der Zeitbereiche (PT) zu verhindern.

4. Verfahren nach Anspruch 3, wobei ein beliebiger der bestimmten Betriebszeitbereiche (PT) den Zeitpunkt des Durchgangs durch einen Nullwert der Versorgungswechselspannung (AC) des Stromnetzes umfasst, und gegebenenfalls umfasst die bestimmte Betriebscharakteristik des Induktionsgenerators den Schallpegel des Geräusches, das der Induktionsgenerator bei der Übertragung von Energie vom Induktionsgenerator auf ein zu erwärmendes Utensil abgibt, oder die Temperaturänderung des zu erwärmenden Utensils, und gegebenenfalls umfasst die bestimmte Betriebscharakteristik des Aktuators die Drehzahl oder das Drehmoment des Motors.

5. Verfahren nach einem der Ansprüche 1 oder 2, wobei der Aktuator (6) ein Gleichstrommotor oder ein Permanentmagnet-Synchronmotor ist, wobei jedem dieser Motoren eine elektronische Schaltung zugeordnet ist, die angeordnet ist, um den Betrieb des Motors in einem Generatormodus während der Zeitbereiche zu verhindern.

6. Verfahren nach Anspruch 5, wobei ein beliebiger der bestimmten Betriebszeitbereiche (PT) den Zeitpunkt des Durchgangs durch den Maximal- und/oder Minimalwert der Versorgungswechselspannung (AC) des Stromnetzes umfasst und die bestimmte Betriebscharakteristik des Motors die Drehzahl oder das Drehmoment des Motors umfasst.

7. Elektrische Einrichtung, die mit einer Wechselspannung elektrisch versorgt wird, und umfassend:
- einen Aktuator (6),
- eine Erfassungskette, die einen Stromsensor (1) zum Messen oder Schätzen des durch den Aktuator (6) fließenden Stroms umfasst, und
in dem Fall, in dem der Aktuator (6) ein Motor ist, der eine Generatorbetriebsart umfasst, dann die elektrische Einrichtung eine elektronische Schaltung umfasst, die mit dem Motor verbunden und so angeordnet ist, dass sie den Betrieb des Motors in seiner Generatorbetriebsart während der Zeitbereiche verhindert,
- Synchronisationsmittel zum Bestimmen einer Vielzahl von periodischen Betriebszeitbereichen (PT) des Aktuators (6) zum dynamischen Ausführen einer Kompensationssequenz (SC) des Versatzfehlers der Erfassungskette während eines beliebigen aus der Vielzahl von bestimmten Betriebszeitbereichen (PT), wobei die Synchronisationsmittel ein Synchronisationsmodul (7) umfassen, das so angeordnet ist, dass es Referenzzeitpunkte (Ref) aus der Versorgungswechselspannung (AC) des Stromnetzes identifiziert,
- Verarbeitungsmittel, die zur Durchführung eines Verfahrens nach einem der Ansprüche 1 bis 6 angeordnet sind.

8. Elektrische Einrichtung nach Anspruch 7, wobei der Aktuator ein Induktionsgenerator (6a), ein von einer geeigneten Elektronik angesteuerter Asynchronmotor, ein Permanentmagnet-Synchronmotor oder ein Universalmotor (6b) ist.

## Claims

1. Method for dynamic compensation for the offset error of an acquisition system comprising a current sensor (1) arranged to measure or estimate a current passing through an actuator (6) of an electrical apparatus that is electrically powered by an AC voltage, said acquisition system having a predetermined offset value, and said method comprising the following steps:
- determining a plurality of periodic temporal operating ranges (PT) of the actuator (6) to dynamically apply a compensation sequence (SC) for the offset error of the acquisition system,
- executing the compensation sequence (SC) during any one of the plurality of determined temporal operating ranges (PT),
the synchronization between the any one of the determined temporal operating ranges (PT) of the actuator (6) and the execution of the compensation sequence (SC) being performed using synchronization means comprising a synchronization module (7) arranged to identify reference times (Ref) from the mains AC supply voltage (AC), said compensation sequence (SC) comprising the following steps:
(i) shutting off the electrical power supply to the actuator so as to interrupt the passage of current in the current sensor (1),
(ii) waiting for a predetermined period at the end of which it is considered or expected that current is no longer passing through the current sensor (1),
(iii) measuring an actual offset value of the acquisition system,
(iv) considering the actual offset value as the new offset value of the acquisition system,
(v) electrically powering the actuator (6) so as to ensure the passage of current in the current sensor (1),
(vi) using the new offset value of the acquisition system to control the actuator (6).

2. Method according to claim 1, in which the temporal ranges (PT) are determined such that the execution of the compensation sequence (SC) does not modify the value of a determined operating characteristic of the actuator (6) beyond a determined threshold.

3. The method according to one of claims 1 or 2, in which the actuator (6) is an induction generator, a universal motor or an asynchronous motor controlled by appropriate electronics, the asynchronous motor being associated with an electronic circuit arranged to prevent the motor from operating in a generator mode during the temporal ranges (PT).

4. Method according to claim 3, in which the any one of the determined temporal operating ranges (PT) comprises the time at which the mains AC supply voltage (AC) crosses zero, and if applicable the determined operating characteristic of the induction generator comprises the sound level of the noise emitted by the induction generator during the transmission of energy from the induction generator to a utensil to be heated, or the variation in temperature of the utensil to be heated and if applicable the determined operating characteristic of the actuator comprises the rotation speed or torque of the motor.

5. Method according to one of claims 1 or 2, in which the actuator (6) is a direct current motor or a permanent magnet synchronous motor, each of these motors being associated with an electronic circuit designed to prevent the motor from operating in a generator mode during the temporal ranges.

6. Method according to claim 5, in which the any one of the determined temporal operating ranges (PT) comprises the time at which the mains AC supply voltage (AC) crosses the maximum and/or minimum value, and the determined operating characteristic of the motor comprises the speed of rotation or torque of the motor.

7. Electrical apparatus intended to be electrically powered by AC voltage, and comprising:
- an actuator (6),
- an acquisition system comprising a current sensor (1) arranged to measure or estimate the current passing through the actuator (6), and
in the event that the actuator (6) is a motor with a generator operating mode, then the electrical apparatus comprises an electronic circuit connected to the motor and arranged to prevent the motor from operating in its generator mode during the temporal ranges,
- synchronization means to determine a plurality of periodic temporal operating ranges (PT) of the actuator (6) to dynamically execute a compensation sequence (SC) for the offset error of the acquisition system during the any one of the plurality of determined temporal operating ranges (PT), the synchronization means comprising a synchronization module (7) arranged to identify reference times (Ref) from the mains AC supply voltage (AC),
- processing means arranged to implement a method according to one of claims 1 to 6.

8. Electrical apparatus according to claim 7, in which the actuator is an induction generator (6a), an asynchronous motor controlled by appropriate electronics, a permanent magnet synchronous motor or a universal motor (6b).
